(19) Europäisches Patentamt / European Patent Office / Office européen des brevets

(11) **EP 2 864 737 B1**

(12) **FASCICULE DE BREVET EUROPEEN**

(45) Date de publication et mention de la délivrance du brevet:
**24.06.2020 Bulletin 2020/26**

(21) Numéro de dépôt: **13744614.2**

(22) Date de dépôt: **24.06.2013**

(51) Int Cl.:
**G01D 5/22** *(2006.01)*          **G01D 18/00** *(2006.01)*

(86) Numéro de dépôt international:
**PCT/FR2013/051466**

(87) Numéro de publication internationale:
**WO 2014/001698 (03.01.2014 Gazette 2014/01)**

(54) **SURVEILLANCE D'UN CAPTEUR DE TYPE TRANSFORMATEUR DIFFERENTIEL VARIABLE LINEAIRE**

ÜBERWACHUNG EINES LINEAREN VARIABLEN DIFFERENZIALTRANSFORMATORSENSORS

MONITORING A LINEAR VARIABLE DIFFERENTIAL TRANSFORMER SENSOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.06.2012 FR 1255996**

(43) Date de publication de la demande:
**29.04.2015 Bulletin 2015/18**

(73) Titulaire: **Safran Aircraft Engines**
**75015 Paris (FR)**

(72) Inventeurs:
• **CABRET, Vincent**
**F-77550 Moissy-Cramayel Cedex (FR)**
• **DJELASSI, Cedrik**
**F-77550 Moissy-Cramayel Cedex (FR)**

(74) Mandataire: **Brevalex**
**95, rue d'Amsterdam**
**75378 Paris Cedex 8 (FR)**

(56) Documents cités:
**EP-A1- 1 132 718     DE-A1- 10 036 935**

## Description

### DOMAINE TECHNIQUE

La présente invention concerne de manière générale le domaine de surveillance d'une chaîne de mesure, par exemple d'un moteur d'aéronef. Elle concerne plus particulièrement la surveillance de contacts intermittents pouvant affecter des capteurs de type transformateur différentiel variable linéaire dit LVDT (d'après l'anglais « Linear Variable Differential Transformer ») de la chaîne de mesure.

### ÉTAT DE LA TECHNIQUE ANTÉRIEURE

Une chaîne de mesure, par exemple d'un moteur d'aéronef, comporte des capteurs LVDT qui sont des capteurs électriques inductifs de déplacements linéaires. Les capteurs LVDT sont notamment utilisés pour l'asservissement en position des aubes à calage variable de stator VSV (d'après l'anglais « Variable Stator Vane »), des vannes de décharge VBV (d'après l'anglais « Variable Bleed Valve ») ou encore du doseur de carburant. Les capteurs LVDT sont également utilisés pour la régulation du jeu de turbine haute pression HPTCC (d'après l'anglais « High Pressure Turbine Clearance Control »).

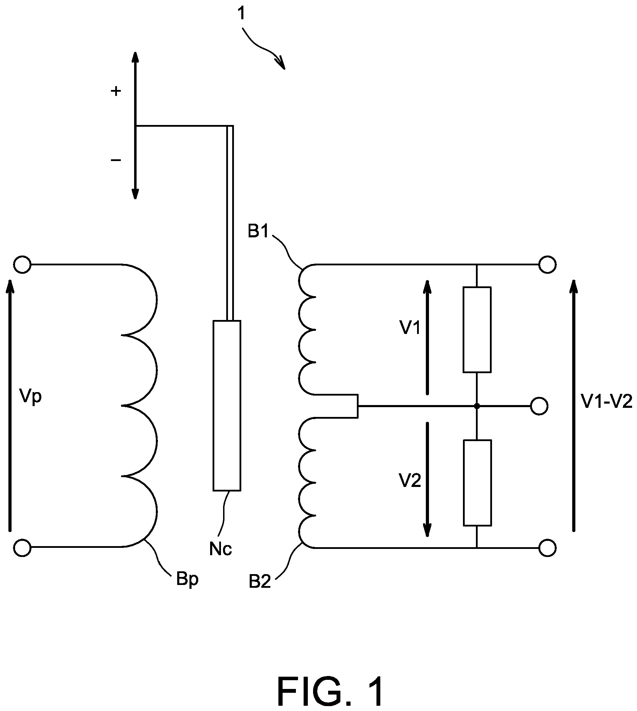

En référence à la **figure 1,** un capteur LVDT 1 comporte un transformateur qui lui-même comporte un circuit primaire formé par une bobine Bp et deux circuits secondaires formés chacun par une bobine B1, B2. Ces trois bobines sont cylindriques et coaxiales. Lorsque la bobine primaire Bp est alimentée par une tension Vp par exemple sinusoïdale, une tension secondaire V1, V2 existe aux bornes de chacune des bobines secondaires B1 et B2.

Le capteur LVDT 1 comporte également un noyau central NC susceptible de se déplacer dans l'axe des bobines. Le déplacement du noyau provoque une modification des champs magnétiques à l'intérieur du transformateur. Plus précisément, lorsque le noyau est déplacé à partir d'une position centrale, la tension induite dans l'une des bobines secondaires augmente et la tension induite dans l'autre bobine secondaire diminue. Cela produit une tension de sortie différentielle (V1-V2) qui varie linéairement en fonction de la position du noyau.

Le capteur LVDT 1 peut fonctionner en mode différentiel, sa sortie est alors la tension différentiel (V1-V2), ou en mode différentiel sur somme, sa sortie est alors la différence des tensions des deux circuits secondaires rapportée à leur somme (V1-V2)/(V1+V2).

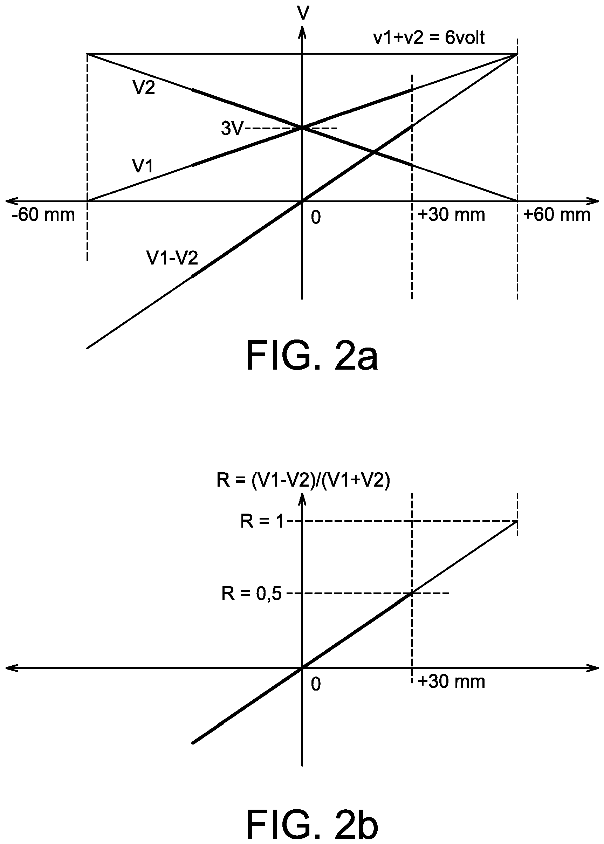

La **figure 2a** représente la variation des tensions V1 et V2 aux bornes de chacune des deux bobines secondaires B1 et B2 ainsi que la variation de la tension différentielle (V1-V2) aux bornes de l'ensemble des deux bobines, en fonction du déplacement du noyau central NC.

La **figure 2b** représente la variation du ratio R de la tension différentielle rapportée à la somme des tensions secondaires (V1-V2)/(V1+V2), en fonction du déplacement du noyau central NC.

Une telle chaîne de mesure fonctionne dans un environnement dans lequel existent de fortes contraintes thermiques et vibratoires. Ces contraintes provoquent fréquemment des pannes de type contact intermittent. Un contact intermittent est une ouverture intermittente et très brève du circuit électrique ou un retour intempestif à la masse.

Lorsque des contacts intermittents se produisent sur l'une des bobines secondaires, la tension mesurée aux bornes de cette bobine est hachée. Après redressage, la valeur RMS obtenue et qui est exploitée par le calculateur prend des valeurs anormalement basses et évolue de manière erratique en fonction de la densité de micro-coupures. Par conséquent, la position calculée à partir des mesures fournies par le capteur LVDT est erratique et entachée de pics haut ou bas, selon la localisation de la panne sur l'une ou l'autre des bobines.

Il existe également des contacts intermittents par mise à la masse, qui est commune aux deux bobines secondaires. Dans ce cas, les tensions mesurées aux bornes des deux bobines secondaires sont affectées par la panne et sont erratiquement basses.

Il est connu qu'un calculateur analyse les données entrées pour vérifier leur validité. Pour cela, le calculateur peut utiliser trois types principaux de tests.

Le premier type est celui des tests d'intégrité électrique. Ces tests sont appliqués sur les mesures de tension aux bornes des bobines secondaires du capteur LVDT.

Un premier test d'intégrité électrique est la vérification que les mesures de tension aux bornes des bobines secondaires sont comprises dans un intervalle prédéterminé, ce qui permet de détecter un circuit ouvert franc et un court-circuit, c'est-à-dire une panne « franche ». Cependant, ce test n'est pas conçu pour détecter un circuit ouvert intermittent, car dans ce cas les tensions mesurées restent dans l'intervalle prédéterminé.

Un second test d'intégrité électrique est la vérification que la somme des mesures de tension aux bornes des bobines secondaires est comprise entre une valeur minimale et une valeur maximale. En effet, le capteur LVDT a la propriété que la somme des tensions secondaires est quasi-constante quelle que soit la position du noyau mobile. Ce test permet de détecter des dérives électriques causées par des défauts d'isolement. Ce test n'est cependant pas satisfaisant en cas de contact intermittent.

En effet, le suivi de la somme des mesures de tension aux bornes des bobines secondaires doit être fait dans un intervalle de valeurs assez grand pour prendre en compte d'éventuelles imperfections de la source d'alimentation (amplitude ou fréquence du signal d'excitation) qui ne sont pas des pannes. En d'autres termes, l'intervalle défini par la valeur maximale et la valeur minimale est large, si bien qu'il est possible que la somme des tensions fluctue en raison de contacts intermittents sans sortir de l'intervalle. Le défaut n'est alors pas détecté.

De plus, lorsque ce test détecte une panne intermittente, la somme des mesures de tensions peut sortir de l'intervalle de validité de manière brève, puis revenir dans l'intervalle de validité, etc. Il y a donc détection intermittente, ce qui a pour conséquence que la mesure de position sélectionnée alterne entre une valeur erronée (quand le calculateur ne détecte pas de panne) et une valeur de reconfiguration saine (quand le calculateur détecte une panne), ce qui déstabilise le système.

Le deuxième type de test est un test de vraisemblance (ou test de range ou de zone). Ce test est appliqué sur la position calculée à partir des deux tensions secondaires du capteur LVDT. La position calculée est comparée à un seuil minimal et un seuil maximal. Ce type de test ne détecte donc que des positions aberrantes, et ne détecte pas de petites oscillations.

Le troisième type de test est un test d'écart. Lorsque les deux types de test précédents n'ont pas détecté de problèmes sur les mesures du capteur LVDT, on peut déterminer la position du noyau mobile. Or il y a toujours deux capteurs LVDT en redondance, il est donc possible de vérifier que la position déterminée est cohérente avec celle déterminée à partir d'un second capteur LVDT redondant. Dans le cas où les deux positions déterminées sont en écart entre elles, cela signifie qu'au moins une de ces mesures est erronée. Cependant, la détection d'un écart entre les mesures ne permet pas de localiser lequel des deux capteurs est en panne.

Ainsi, il apparait que les tests de validité connus ne sont pas satisfaisants en cas de contact intermittent.

Le document EP 1 132 718 divulgue un procédé et un dispositif pour détecter des défauts dans un capteur de type transformateur différentiel variable linéaire. Cet enseignement repose sur la vérification que la somme des mesures de tension aux bornes des bobines secondaires reste sensiblement constante, et est donc comprise entre une valeur minimale et une valeur maximale.

Ce document ne divulgue pas la mise à jour d'un indicateur de panne du capteur.

Le document DE 100 36 935 concerne la détection de dysfonctionnement d'un capteur qui fournit deux signaux de sortie mutuellement inverses.

Ce document ne concerne pas un transformateur différentiel avec un noyau qui se déplace. De plus, il n'utilise pas l'évolution de la somme des gradients des tensions de sortie.

## EXPOSÉ DE L'INVENTION

L'invention vise à résoudre les problèmes de la technique antérieure en fournissant un procédé de surveillance d'un capteur de type transformateur différentiel variable linéaire comportant deux circuits secondaires dans lesquels est respectivement induite une tension variant linéairement en fonction du déplacement d'un noyau, caractérisé en ce qu'il comporte les étapes itératives de :

- Calcul de la différence entre les tensions aux bornes de l'un des circuits secondaires à un instant donné et à un instant précédent,
- Calcul de la différence entre les tensions aux bornes de l'autre des circuits secondaires à l'instant donné et à l'instant précédent,
- Calcul de la somme des deux différences précédemment calculées,
- Modification de la valeur d'un indicateur de panne du capteur variant entre deux bornes, dont l'une indique que le capteur fonctionne normalement, et l'autre indique que le capteur est en panne, par incrémentation de la valeur de l'indicateur si la somme précédemment calculée est proche de zéro et par décrémentation de la valeur de l'indicateur si la somme précédemment calculée est éloignée de zéro, et
- Comparaison de la valeur de l'indicateur à au moins un seuil prédéterminé.

Grâce à l'invention, une panne de type contact intermittent est détectée et les valeurs aberrantes sont identifiées et peuvent être supprimées de tout traitement ultérieur, tel qu'une régulation.

L'invention s'applique directement sur les mesures de tension d'un seul et même capteur. Le problème de localisation du capteur en panne est alors éliminé, puisqu'on peut auto-tester le capteur.

La somme calculée est proche de zéro lorsque le capteur fonctionne normalement, et s'éloigne de zéro en cas de contact intermittent. Ainsi, la valeur de l'indicateur évolue en fonction du fonctionnement normal du capteur ou de l'existence de contact intermittent.

L'indicateur garde en mémoire un historique des variations des tensions mesurées et permet une détection « non intermittente » d'une panne intermittente.

L'indicateur augmente en cas de fonctionnement normal du capteur et décroit en cas de contact intermittent.

Selon une caractéristique préférée, la comparaison de l'indicateur comporte la comparaison à un premier seuil et à un second seuil, de manière à ce que le passage d'un état de fonctionnement normal à un état de panne soit effectué pour une valeur différente de celle du passage inverse.

Ainsi un phénomène d'hystérésis est créé, ce qui évite de déclarer un capteur en panne de manière intermittente.

L'invention concerne aussi un dispositif de surveillance d'un capteur de type transformateur différentiel variable linéaire comportant deux circuits secondaires dans lesquels est respectivement induite une tension variant linéairement en fonction du déplacement d'un noyau, caractérisé en ce qu'il comporte :

- Un moyen de calcul de la différence entre les tensions aux bornes de l'un des circuits secondaires à un instant donné et à un instant précédent,
- Un moyen de calcul de la différence entre les tensions aux bornes de l'autre des circuits secondaires à l'instant donné et à l'instant précédent,
- Un moyen de calcul de la somme des deux différences précédemment calculées,
- Un moyen de modification de la valeur d'un indicateur de panne du capteur variant entre deux bornes, dont l'une indique que le capteur fonctionne normalement, et l'autre indique que le capteur est en panne, par incrémentation de la valeur de l'indicateur si la somme précédemment calculée est proche de zéro et par décrémentation de la valeur de l'indicateur si la somme précédemment calculée est éloignée de zéro, et
- Un moyen de comparaison de la valeur de l'indicateur à au moins un seuil prédéterminé.

L'invention concerne encore une chaîne de mesure intégrant un capteur de type transformateur différentiel variable linéaire comportant deux circuits secondaires dans lesquels est respectivement induite une tension variant linéairement en fonction du déplacement d'un noyau, et un dispositif de surveillance tel que précédemment présenté.

Le dispositif et la chaîne de mesure selon l'invention présentent des avantages analogues à ceux précédemment présentés.

Dans un mode particulier de réalisation, les étapes du procédé selon l'invention sont mises en œuvre par des instructions de programme d'ordinateur.

En conséquence, l'invention vise aussi un programme d'ordinateur sur un support d'informations, ce programme étant susceptible d'être mis en œuvre dans un ordinateur, ce programme comportant des instructions adaptées à la mise en œuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

**BRÈVE DESCRIPTION DES DESSINS**

D'autres caractéristiques et avantages apparaîtront à la lecture d'un mode de réalisation préféré donné à titre d'exemple non limitatif, décrit en référence aux figures dans lesquelles :

- La figure 1 représente un capteur LVDT,
- La figure 2a représente les tensions secondaires du capteur LVDT en fonction d'un déplacement,
- La figure 2b représente la tension différentielle divisée par la somme des tensions secondaires, en fonction d'un déplacement,
- La figure 3 représente un mode de réalisation du dispositif selon l'invention,
- La figure 4 représente une loi d'incrémentation d'un indicateur selon l'invention, et
- La figure 5 représente un mode de réalisation du procédé selon l'invention, sous la forme d'un organigramme.

**EXPOSÉ DÉTAILLÉ DE MODES DE RÉALISATION PARTICULIERS**

Les figures 1, 2a et 2b ont déjà été décrites.

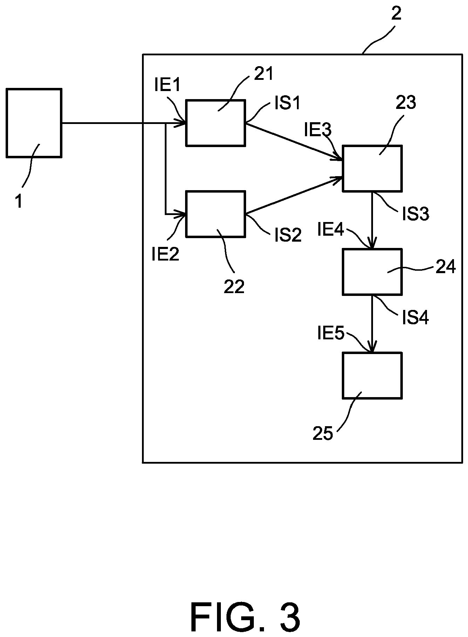

La **figure 3** représente schématiquement une chaîne de mesure, par exemple d'un moteur ou turboréacteur d'aéronef. La chaîne de mesure comporte de manière générale deux voies redondées destinées à recueillir au cours du temps des mesures physiques, telles que températures, pressions, positions, etc.

Ces mesures physiques sont effectuées via un ensemble de capteurs, dont seul un capteur LVDT 1 est représenté à la figure 3. Le capteur LVDT est relié à un calculateur 2, par exemple un FADEC, qui exploite les mesures fournies par les capteurs. Ces mesures sont effectuées à une fréquence donnée. On note $V1_t$ et $V2_t$ les tensions respectivement mesurées aux bornes des bobines secondaires B1 et B2, à un instant donné. Ces valeurs mesurées sont mémorisées dans une mémoire interne du calculateur ou dans une mémoire associée à celui-ci.

Selon l'invention, un dispositif de surveillance du capteur LVDT 1 est associé au calculateur 2 ou intégré à celui-ci. Dans les deux cas, le dispositif de surveillance du capteur LVDT a la structure générale d'un ordinateur. Selon le mode de réalisation représenté à la figure 3, le dispositif de surveillance du capteur LVDT 1 est intégré au calculateur 2. Seules les caractéristiques directement liées à l'invention sont représentées et décrites, les autres caractéristiques du calculateur étant bien connues de l'homme du métier.

Le dispositif de surveillance comporte une interface d'entrée IE1 reliée à un module 21 de calcul de la différence entre les tensions aux bornes de l'un des circuits secondaires à un instant donné t et à un instant précédent (t-1). Par exemple, le module 21 calcule la différence : $\Delta 1_t = V1_t - V1_{t-1}$.

Le dispositif de surveillance comporte aussi une interface d'entrée IE2 reliée à un module 22 de calcul de la différence entre les tensions aux bornes de l'autre des circuits secondaires à l'instant donné t et à l'instant précédent (t-1). Par exemple, le module 22 calcule la différence : $\Delta 2_t = V2_t - V2_{t-1}$.

Pour les deux calculs de différence de tension précédents, le pas de temps est par exemple de 15 ms.

Ces deux modules de calcul peuvent être mis en œuvre dans un seul module. Ils comportent une interface de sortie respective IS1, IS2 qui est reliée à une interface d'entrée IE3 d'un module 23 de calcul de la somme des deux différences précédemment calculées :

$$S_t = \Delta 1_t + \Delta 2_t.$$

En théorie, la somme $S_t$ est strictement égale à zéro car un déplacement du noyau mobile induit une augmentation, respectivement diminution, de la tension aux bornes de l'une des bobines secondaires, et simultanément une diminution, respectivement augmentation, de la tension aux bornes de l'autre des bobines secondaires, qui sont égales en valeur absolue.

En pratique, il existe des imperfections qui font que les tensions mesurées ne varient pas strictement linéairement en fonction de la position du noyau. Pour s'affranchir de ces imperfections, si la somme $S_t$ reste dans un intervalle de valeurs proches de zéro, le fonctionnement du capteur est considéré comme normal. Les bornes de cet intervalle sont proches de zéro et peuvent être déterminées expérimentalement.

Ce module 23 comporte une interface de sortie IS3 qui est reliée à une interface d'entrée IE4 d'un module 24 d'actualisation d'un indicateur de santé IND dont la fonction est d'indiquer une panne.

L'indicateur IND varie entre deux bornes, par exemple 0 et 100. L'une des valeurs, la valeur 100, indique que le capteur fonctionne normalement, et l'autre valeur, la valeur 0, indique que le capteur est en panne.

Le module 24 fait varier la valeur de l'indicateur IND entre ses bornes, en fonction de la valeur de la somme $S_t$ fournie par le module 23. Plus précisément, l'actualisation de l'indicateur comporte une modification de la valeur de l'indicateur en fonction de la distance à zéro de la somme précédemment calculée.

Cette somme est proche de zéro lorsque le capteur fonctionne normalement, et s'éloigne de zéro en cas de contact intermittent. Ainsi, la valeur de l'indicateur évolue en fonction du fonctionnement normal du capteur ou de l'existence de contact intermittent.

L'indicateur IND est initialisé à la valeur 100. L'indicateur IND est fortement décrémenté si la somme $S_t$ indique une panne de type intermittent, c'est-à-dire si la somme $S_t$ est éloignée de zéro. L'indicateur IND est faiblement incrémenté si la somme $S_t$ indique un fonctionnement normal du capteur, c'est-à-dire si la somme $S_t$ est proche de zéro.

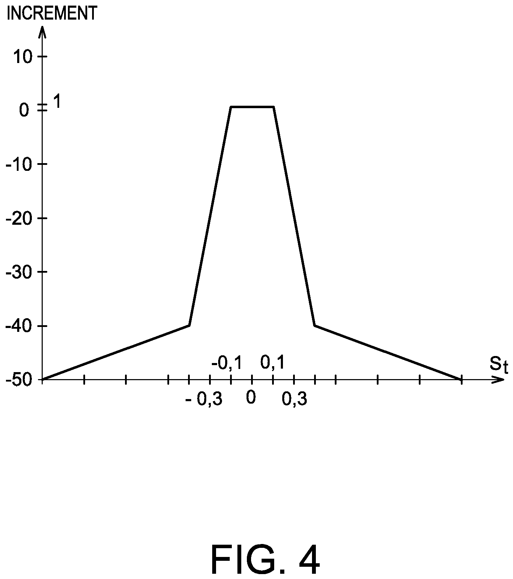

Par exemple, l'incrémentation de l'indicateur IND est réalisée selon un incrément tel que représenté à la **figure 4.**

Pour une somme $S_t$ comprise entre -0.1 et +0.1, l'incrément vaut 1.

Pour une somme $S_t$ comprise entre +0.1 et +0.3 ou entre -0.1 et -0.3, l'incrément décroit linéairement de 1 à -40.

Pour une somme $S_t$ comprise entre +0.3 et +1 ou entre -0.3 et -1, l'incrément décroit linéairement de -40 à -50.

L'incrément est appliqué à l'indicateur IND, tout en maintenant ce dernier entre ses bornes, c'est-à-dire que l'incrément n'est pas appliqué, ou n'est que partiellement appliqué, si l'indicateur arrive à l'une de ses bornes.

Il est à noter également que l'indicateur IND peut être figé lorsqu'il atteint la valeur zéro. On considère dans ce cas que le capteur est trop dégradé. Même si l'intermittence du contact s'atténue par la suite, le capteur ne pourra pas être redéclaré valide à nouveau. En d'autres termes, le fait de figer l'indicateur à zéro empêche toute réhabilitation du capteur LVDT.

Bien entendu, d'autres lois de variation de l'incrément de l'indicateur IND en fonction de la somme $S_t$ sont possibles. La courbe peut être composée de segments linéaires en plus grand ou en plus petit nombre. La courbe peut aussi être en cloche ou encore en gaussienne.

Le module 24 comporte une interface de sortie IS4 qui est reliée à une interface d'entrée IE5 d'un module 25 de détermination d'un statut de validité du capteur. Cette détermination est basée sur la comparaison de l'indicateur IND avec au moins un seuil prédéterminé.

De préférence, la comparaison de l'indicateur comporte la comparaison à un premier seuil et à un second seuil, de manière à ce que le passage d'un état de fonctionnement normal à un état de panne soit effectué pour une valeur différente de celle du passage inverse.

L'indicateur IND étant initialisé à 100, s'il reste ensuite supérieur à un premier seuil, dit seuil bas, valant par exemple 50, le capteur est déclaré comme fonctionnant normalement. Si l'indicateur IND devient inférieur au premier seuil, une panne de type contact intermittent du capteur est détectée.

L'indicateur IND étant inférieur au premier seuil, s'il reste ensuite inférieur à un second seuil, dit seuil haut, supérieur au premier seuil, valant par exemple 90, le capteur reste déclaré en panne. Si l'indicateur IND devient supérieur au second seuil, alors le capteur est déclaré comme fonctionnant normalement.

Ce fonctionnement en hystérésis permet d'éviter de détecter une panne de façon intermittente. Bien entendu, dans un mode simplifié, il est possible de n'utiliser qu'un seul seuil, ou en d'autres termes de choisir un seuil bas et un seuil haut égaux.

Bien entendu, le dispositif de surveillance peut surveiller une pluralité de capteur LVDT inclus dans la chaîne de mesure.

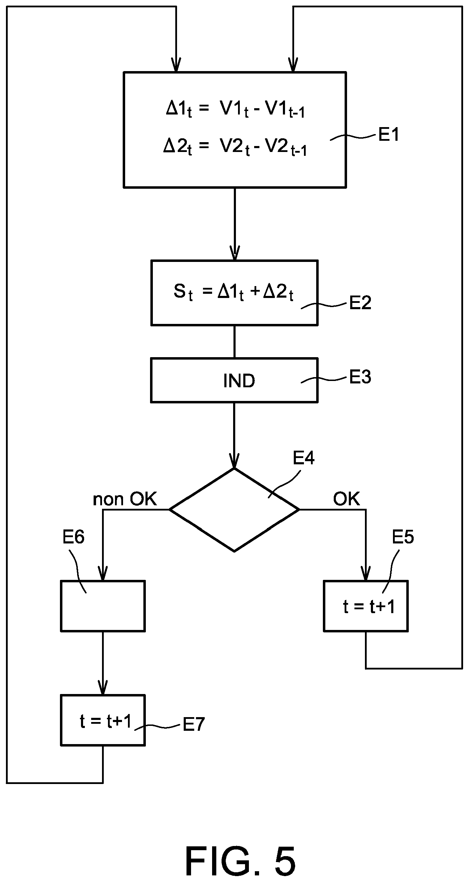

Le fonctionnement du dispositif de surveillance de capteur LVDT est décrit en référence à la **figure 5,** sous la forme d'un organigramme comportant des étapes E1 à E7.

Les étapes E1 à E7 sont effectuées itérativement, par exemple à une fréquence prédéterminée correspondant à la fréquence de mesure des tensions V1 et V2 du capteur LVDT. Le pas de temps est par exemple de 15 ms.

L'étape E1 est le calcul d'une différence entre la tension mesurée à un instant courant et celle mesurée à l'instant précédent, pour chacune des deux bobines secondaires :

$$\Delta 1_t = V1_t - V1_{t-1}$$

$$\Delta 2_t = V2_t - V2_{t-1}$$

L'étape suivante E2 est le calcul de la somme des deux différences précédemment calculées :

$$S_t = \Delta 1_t + \Delta 2_t$$

L'étape suivante E3 est l'actualisation d'un indicateur de santé IND dont la fonction est d'indiquer une panne.

L'indicateur IND varie entre deux bornes, par exemple 0 et 100. L'une des valeurs, la valeur 100, indique que le capteur fonctionne normalement, et l'autre valeur, la valeur 0, indique que le capteur est en panne.

L'étape E3 modifie la valeur de l'indicateur IND entre ses bornes, en fonction de la valeur de la somme $S_t$ calculée à l'étape précédente. Plus précisément, l'actualisation de l'indicateur comporte une modification de la valeur de l'indicateur en fonction de la distance à zéro de la somme précédemment calculée.

Cette somme est proche de zéro lorsque le capteur fonctionne normalement, et s'éloigne de zéro en cas de contact intermittent. Ainsi, la valeur de l'indicateur évolue à l'étape E3 en fonction du fonctionnement normal du capteur ou de l'existence de contact intermittent.

L'indicateur IND est initialisé à la valeur 100. L'indicateur IND est fortement décrémenté si la somme $S_t$ indique une panne de type intermittent, c'est-à-dire si la somme $S_t$ est éloignée de zéro. L'indicateur IND est faiblement incrémenté si la somme $S_t$ indique un fonctionnement normal du capteur, c'est-à-dire si la somme $S_t$ est proche de zéro.

Par exemple, l'incrémentation de l'indicateur IND est réalisée selon un incrément tel que représenté à la **figure 4** précédemment décrite.

L'incrément est appliqué à l'indicateur IND, tout en maintenant ce dernier entre ses bornes, c'est-à-dire que l'incrément n'est pas appliqué, ou n'est que partiellement appliqué, si l'indicateur arrive à l'une de ses bornes.

Il est possible d'imposer que l'indicateur reste figé à la valeur zéro s'il l'atteint, de manière à empêcher un capteur LVDT dégradé d'être requalifié ultérieurement comme valide.

Bien entendu, d'autres lois de variation de l'incrément de l'indicateur IND en fonction de la somme $S_t$ sont possibles. La courbe peut être composée de segments linéaires en plus grand ou en plus petit nombre. La courbe peut aussi être en cloche ou encore en gaussienne.

L'étape suivante E4 est la détermination d'un statut de validité du capteur. Cette détermination est basée sur la comparaison de l'indicateur IND avec au moins un seuil prédéterminé.

De préférence, la comparaison de l'indicateur comporte la comparaison à un premier seuil et à un second seuil, de manière à ce que le passage d'un état de fonctionnement normal à un état de panne soit effectué pour une valeur différente de celle du passage inverse.

L'indicateur IND étant initialisé à 100, s'il reste ensuite supérieur à un premier seuil, dit seuil bas, valant par exemple 50, le capteur est déclaré comme fonctionnant normalement. Si l'indicateur IND devient inférieur au premier seuil, une panne de type contact intermittent du capteur est détectée.

L'indicateur IND étant inférieur au premier seuil, s'il reste ensuite inférieur à un second seuil, dit seuil haut, supérieur au premier seuil, valant par exemple 90, le capteur reste déclaré en panne. Si l'indicateur IND devient supérieur au second seuil, alors le capteur est déclaré comme fonctionnant normalement.

Ce fonctionnement en hystérésis permet d'éviter de détecter une panne de façon intermittente. Bien entendu, dans un mode simplifié, il est possible de n'utiliser qu'un seul seuil, ou en d'autres termes de choisir un seuil bas et un seuil haut égaux.

Si le capteur est déclaré comme fonctionnant normalement, alors l'étape E4 est suivie de l'étape E5 à laquelle le paramètre temps est incrémenté d'un pas. L'étape E5 est suivie de l'étape E1 précédemment décrite, effectuée au pas de temps suivant.

Si le capteur est déclaré comme affecté par une panne de type contact intermittent, alors l'étape E4 est suivie de l'étape E6 à laquelle une alerte est créée pour attribuer un label « invalide » aux valeurs de tension $V1_t$ et $V2_t$ mesurées à l'instant t. Le calculateur 2 peut ainsi écarter ces valeurs pour les traitements ultérieurs.

A l'étape suivante E7, le paramètre temps est incrémenté d'un pas. L'étape E7 est suivie de l'étape E1 précédemment décrite, effectuée au pas de temps suivant.

Le procédé selon l'invention peut être mis en œuvre au fur et à mesure de l'acquisition des mesures, ou en variante il peut être mis en œuvre sur un ensemble de valeurs préalablement mesurées et mémorisées.

L'invention peut être mise en œuvre en complément des tests de validité connus, tels que test électrique, test de vraisemblance et test d'écart.

## Revendications

1. Procédé de surveillance d'un capteur (1) de type transformateur différentiel variable linéaire comportant deux circuits secondaires (B1, B2) dans lesquels est respectivement induite une tension variant linéairement en fonction du déplacement d'un noyau, **caractérisé en ce qu'**il comporte les étapes itératives de :

   - Calcul (E1) de la différence entre les tensions aux bornes de l'un des circuits secondaires à un instant donné et à un instant précédent,
   - Calcul (E1) de la différence entre les tensions aux bornes de l'autre des circuits secondaires à l'instant donné et à l'instant précédent,
   - Calcul (E2) de la somme des deux différences précédemment calculées,
   - Modification (E3) de la valeur d'un indicateur de panne du capteur variant entre deux bornes, dont l'une indique que le capteur fonctionne normalement, et l'autre indique que le capteur est en panne, par incrémentation de la valeur de l'indicateur si la somme précédemment calculée est proche de zéro et par décrémentation de la valeur de l'indicateur si la somme précédemment calculée est éloignée de zéro, et
   - Comparaison (E4) de la valeur de l'indicateur à au moins un seuil prédéterminé.

2. Procédé de surveillance selon la revendication 1, **caractérisé en ce que** la comparaison de la valeur de l'indicateur comporte la comparaison à un premier seuil et à un second seuil, de manière à ce que le passage d'un état de fonctionnement normal à un état de panne soit effectué pour une valeur différente de celle du passage inverse.

3. Dispositif de surveillance d'un capteur de type transformateur différentiel variable linéaire comportant deux circuits secondaires dans lesquels est respectivement induite une tension variant linéairement en fonction du déplacement d'un noyau, **caractérisé en ce qu'**il comporte :

   - Un moyen (21) de calcul de la différence entre les tensions aux bornes de l'un des circuits secondaires à un instant donné et à un instant précédent,
   - Un moyen (22) de calcul de la différence entre les tensions aux bornes de l'autre des circuits secondaires à l'instant donné et à l'instant précédent,
   - Un moyen (23) de calcul de la somme des deux différences précédemment calculées,
   - Un moyen (24) de modification de la valeur d'un indicateur de panne du capteur variant entre deux bornes, dont l'une indique que le capteur fonctionne normalement, et l'autre indique que le capteur est en panne, par incrémentation de la valeur de l'indicateur si la somme précédemment calculée est proche de zéro et par décrémentation de la valeur de l'indicateur si la somme précédemment calculée est éloignée de zéro, et
   - Un moyen (25) de comparaison de la valeur de l'indicateur à au moins un seuil prédéterminé.

4. Chaîne de mesure intégrant un capteur de type transformateur différentiel variable linéaire comportant deux circuits secondaires dans lesquels est respectivement induite une tension variant linéairement en fonction du déplacement d'un noyau, et un dispositif de surveillance selon la revendication 3.

5. Programme d'ordinateur comportant des instructions pour l'exécution des étapes du procédé selon l'une quelconque des revendications 1 à 2 lorsque ledit programme est exécuté par un ordinateur.

6. Support d'enregistrement lisible par un ordinateur sur lequel est enregistré un programme d'ordinateur comprenant des instructions pour l'exécution des étapes du procédé selon l'une quelconque des revendications 1 à 2.

## Patentansprüche

1. Verfahren zur Überwachung eines Sensors (1) in Form eines linear variablen Differenzialtransformators, der zwei Sekundärkreise (B1, B2) umfasst, in denen jeweils eine Spannung induziert wird, die abhängig von der Verschiebung eines Kerns linear variiert, **dadurch gekennzeichnet, dass** es die folgenden iterativen Schritte umfasst:

   - Berechnung (E1) der Differenz zwischen den Spannungen an den Anschlüssen des einen Sekundärkreises zu einem bestimmten Zeitpunkt und zu einem früheren Zeitpunkt,
   - Berechnung (E1) der Differenz zwischen den Spannungen an den Anschlüssen des anderen Sekundärkreises zu diesem bestimmten Zeitpunkt und zu diesem früheren Zeitpunkt,

- Berechnung (E2) der Summe der beiden vorher berechneten Differenzen,

- Änderung (E3) des Wertes einer Störungsanzeige des Sensors, der zwischen zwei Anschlüssen variiert, von denen einer anzeigt, dass der Sensor normal funktioniert, und der andere anzeigt, dass der Sensor fehlerhaft ist, und zwar durch Inkrementieren des Wertes der Anzeige, wenn die zuvor berechnete Summe nahe null liegt, und durch Dekrementieren des Wertes der Anzeige, wenn die zuvor berechnete Summe weit von null entfernt ist, und

- Vergleich (E4) des Wertes der Anzeige mit mindestens einem zuvor festgelegten Schwellenwert.

2. Verfahren zur Überwachung gemäß Anspruch 1, **dadurch gekennzeichnet, dass** der Vergleich des Wertes der Anzeige den Vergleich mit einem ersten Schwellenwert und einem zweiten Schwellenwert umfasst, sodass der Übergang von einem normalen Betriebszustand in einen gestörten Betriebszustand bei einem anderen Wert durchgeführt wird als dem für den umgekehrten Übergang.

3. Vorrichtung zur Überwachung eines Sensors in Form eines linear variablen Differenzialtransformators, der zwei Sekundärkreise umfasst, in denen jeweils eine Spannung induziert wird, die abhängig von der Verschiebung eines Kerns linear variiert, **dadurch gekennzeichnet, dass** sie Folgendes umfasst:

- Ein Mittel (21) zur Berechnung der Differenz zwischen den Spannungen an den Anschlüssen des einen Sekundärkreises zu einem bestimmten Zeitpunkt und zu einem früheren Zeitpunkt,

- Ein Mittel (22) zur Berechnung der Differenz zwischen den Spannungen an den Anschlüssen des anderen Sekundärkreises zu diesem bestimmten Zeitpunkt und zu diesem früheren Zeitpunkt,

- Ein Mittel (23) zur Berechnung der Summe der beiden vorher berechneten Differenzen,

- Ein Mittel (24) zur Änderung des Wertes einer Störungsanzeige des Sensors, der zwischen zwei Anschlüssen variiert, von denen einer anzeigt, dass der Sensor normal funktioniert, und der andere anzeigt, dass der Sensor fehlerhaft ist, und zwar durch Inkrementieren des Wertes der Anzeige, wenn die zuvor berechnete Summe nahe null liegt, und durch Dekrementieren des Wertes der Anzeige, wenn die zuvor berechnete Summe weit von null entfernt ist, und

- Ein Mittel (25) zum Vergleich des Wertes der Anzeige mit mindestens einem zuvor festgelegten Schwellenwert.

4. Messkette, die einen Sensor in Form eines linear variablen Differenzialtransformators mit zwei Sekundärkreisen, in denen jeweils eine Spannung induziert wird, die abhängig von der Verschiebung eines Kerns linear variiert, und eine Vorrichtung zur Überwachung gemäß Anspruch 3 beinhaltet.

5. Computerprogramm, das Anweisungen für die Ausführung der Schritte des Verfahrens gemäß einem der Ansprüche 1 bis 2 umfasst, sofern dieses Programm von einem Computer ausgeführt wird.

6. Aufzeichnungsmedium, das von einem Computer ausgelesen werden kann und auf dem ein Computerprogramm gespeichert wird, welches Anweisungen für die Ausführung der Schritte des Verfahrens gemäß einem der Ansprüche 1 bis 2 umfasst.

**Claims**

1. Method for monitoring a sensor (1) of the linear variable differential transformer type comprising two secondary circuits (B1, B2) in which there is respectively induced a voltage varying linearly according to the movement of a core, **characterised in that** it comprises the iterative steps of:

- calculating (E1) the difference between the voltages at the terminals of one of the secondary circuits at a given instant and at a previous instant,

- calculating (E1) the difference between the voltages at the terminals of the other one of the secondary circuits at the given instant and at the previous instant,

- calculating (E2) the sum of the two differences previously calculated,

- modifying (E3) the value of an indicator indicating a fault of the sensor varying between two terminals, one of which indicates that the sensor is functioning normally and the other one of which indicates that the sensor is faulty, by incrementing the value of the indicator if the previously calculated sum is close to zero and by decrementing the value of the indicator if the previously calculated sum is distant from zero, and

- comparing (E4) the value of the indicator with at least one predetermined threshold.

2. Monitoring method according to claim 1, **characterised in that** the comparison of the value of the indicator comprises the comparison with a first threshold and a second threshold, so that the change from a normal operating state to a fault state is effected for a value different from that of the opposite change.

3. Device for monitoring a sensor of the linear variable differential transformer type comprising two secondary circuits in which there is respectively induced a voltage varying linearly according to the movement of a core, **characterised in that** it comprises:

   - a means (21) for calculating the difference between the voltages at the terminals of one of the secondary circuits at a given instant and at a previous instant,
   - a means (22) for calculating the difference between the voltages at the terminals of the other one of the secondary circuits at the given instant and at the previous instant,
   - a means (23) for calculating the sum of the two differences previously calculated,
   - a means (24) for modifying the value of an indicator indicating a fault of the sensor varying between two terminals, one of which indicates that the sensor is functioning normally and the other one of which indicates that the sensor is faulty, by incrementing the value of the indicator if the previously calculated sum is close to zero and by decrementing the value of the indicator if the previously calculated sum is distant from zero, and
   - a means (25) for comparing the value of the indicator with at least one predetermined threshold.

4. Measuring chain integrating a sensor of the linear variable differential transformer type comprising two secondary circuits in which there is respectively induced a voltage varying linearly according to the movement of a core, and a monitoring device according to claim 3.

5. Computer program comprising instructions for executing steps of the method according to any one of claims 1 to 2 when said program is executed by a computer.

6. Recording medium able to be read by a computer, on which a computer program is recorded comprising instructions for executing the steps of the method according to any one of claims 1 to 2.

1

+

−

Bp

Vp

Nc

B1

V1

V2

V1-V2

B2

# FIG. 1

FIG. 2a

FIG. 2b

FIG. 3

FIG. 4

$$\Delta 1_t = V1_t - V1_{t-1}$$

$$\Delta 2_t = V2_t - V2_{t-1}$$

E1

$$S_t = \Delta 1_t + \Delta 2_t$$

E2

IND

E3

E4

non OK

OK

E6

E5

t = t+1

t = t+1

E7

FIG. 5

**EP 2 864 737 B1**

## RÉFÉRENCES CITÉES DANS LA DESCRIPTION

### Documents brevets cités dans la description

- EP 1132718 A

- DE 10036935